# EUROPEAN PATENT APPLICATION

(11) **EP 4 729 969 A1**
(43) Date of publication of application: **22.04.2026**
(21) Application number: 25749038.3
(22) Date of filing: 24.01.2025
(51) Int. Cl.: G01R 31/392, G01R 31/382, G01R 31/389, G01R 31/396, G01R 19/165, H02J 7/00, B60L 58/16

(54) **BATTERY MANAGEMENT APPARATUS AND METHOD**

(30) Priority: 31.01.2024 KR 20240015218
(71) Applicant: LG Energy Solution, Ltd., Seoul 07335 (KR)
(72) Inventor: SUNG, Yun-Jin, Daejeon 34122 (KR); SUN, Kyung-Eun, Daejeon 34122 (KR); BAE, Yoon-Jung, Daejeon 34122 (KR)
(74) Representative: Goddar, Heinz J.
(86) International application number: PCT/KR2025/001541
(87) International publication number: WO 2025/165135

(57) **Abstract**

A battery management apparatus according to the present disclosure includes a profile obtaining unit configured to obtain a battery profile representing a corresponding relationship between resistance and voltage of a battery; and a control unit configured to determine a voltage pattern and a resistance pattern of the battery based on the battery profile, compare at least one of the voltage pattern and the resistance pattern with a preset diagnosis rule, and diagnose a state of the battery based on the comparison result.

## Description

### TECHNICAL FIELD

The present disclosure relates to a battery management apparatus and method, and more particularly, to a battery management apparatus and method capable of diagnosing a degradation state of a battery by dividing the state into stages and controlling the battery more appropriately based on the diagnosis results.

This application is based on and claims priority from Korean Patent Application No. 10-2024-0015218, filed on January 31, 2024, with the Korean Intellectual Property Office, the disclosure of which is incorporated herein in its entirety by reference.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

Although much research is being conducted on these batteries in terms of high capacity and high density, improving lifespan and safety is also important. In order to improve battery safety, a technology that diagnoses the current degradation state of the battery is required.

In relation to this, research is being conducted to diagnose the degree of battery degradation by tracking the change patterns of the voltage and/or resistance of the battery. In the past, as battery degradation progressed, the voltage increased and the resistance decreased, but the point at which the resistance increased despite the increase in voltage was considered to be the point at which the battery was excessively degraded and became an abnormal state.

However, since the battery degrades gradually, it is required to develop a technology that may diagnose the state of the battery by dividing the state into stages according to the degree of degradation and control the battery more appropriately based on the diagnosis results. In other words, it is required to develop a technology that may prevent accelerated degradation of the battery by diagnosing the degradation state of the battery into more stages and controlling the battery more appropriately based on the diagnosis results, beyond simply diagnosing whether the battery is in an abnormal state.

### DISCLOSURE

### Technical Problem

The present disclosure is designed to solve the problems of the related art, and therefore the present disclosure is directed to providing a battery management apparatus and method capable of diagnosing a degradation state of a battery by dividing the state into stages and controlling the battery more appropriately based on the diagnosis results.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management apparatus according to one aspect of the present disclosure comprises: a profile obtaining unit configured to obtain a battery profile representing a corresponding relationship between resistance and voltage of a battery; and a control unit configured to determine a voltage pattern and a resistance pattern of the battery based on the battery profile, compare at least one of the voltage pattern and the resistance pattern with a preset diagnosis rule, and diagnose a state of the battery based on the comparison result.

The voltage pattern may be configured to include a voltage increase pattern, a voltage decrease pattern, and a voltage constant pattern.

The resistance pattern may be configured to include a resistance increase pattern and a resistance constant pattern.

The control unit may be configured to determine the voltage pattern as the voltage constant pattern when the voltage of the battery is maintained within a preset voltage range, the control unit may be configured to determine the voltage pattern as the voltage increase pattern when the voltage of the battery increases over time and is out of the voltage range, and the control unit may be configured to determine the voltage pattern as the voltage decrease pattern when the voltage of the battery decreases over time and is out of the voltage range.

The control unit may be configured to determine the resistance pattern as the resistance constant pattern when the resistance of the battery is maintained within a preset resistance range, and the control unit may be configured to determine the resistance pattern as the resistance increase pattern when the resistance of the battery increases over time and is out of the resistance range.

The control unit may be configured to diagnose the state of the battery as a normal state when the voltage pattern is the voltage decrease pattern, and the control unit may be configured to diagnose the state of the battery as a degradation state when the voltage pattern is not the voltage decrease pattern.

In case where the state of the battery is the degradation state, the control unit may be configured to diagnose the state of the battery as an initial degradation state when the resistance pattern is the resistance constant pattern, and to diagnose the state of the battery as a mid- or late-stage degradation state when the resistance pattern is the resistance increase pattern.

In case where the state of the battery is the mid- or late-stage degradation state, the control unit may be configured to diagnose the state of the battery as a mid-stage degradation state when the voltage pattern is the voltage constant pattern, and to diagnose the state of the battery as a late-stage degradation state when the voltage pattern is the voltage increase pattern.

The control unit may be configured to set a usage condition for the battery based on the state of the battery.

The voltage that constitutes the battery profile may be a voltage after a discharge termination of the battery.

The resistance that constitutes the battery profile may be a resistance after the discharge termination of the battery.

A battery management apparatus according to another aspect of the present disclosure may further comprise a display coupled with the control unit, and the control unit may be configured to output the diagnosis result through the display.

A battery pack according to another aspect of the present disclosure comprises the battery management apparatus according to one aspect of the present disclosure.

A vehicle according to still another aspect of the present disclosure comprises the battery management apparatus according to one aspect of the present disclosure.

A server according to still another aspect of the present disclosure comprises the battery management apparatus according to one aspect of the present disclosure.

A battery management method according to still another aspect of the present disclosure may comprise: a profile obtaining step of obtaining a battery profile representing a corresponding relationship between resistance and voltage of a battery; a pattern determining step of determining a voltage pattern and a resistance pattern of the battery based on the battery profile; and a state diagnosing step of comparing the voltage pattern and the resistance pattern with a preset diagnosis rule and diagnosing a state of the battery based on the comparison result.

### Advantageous Effects

According to one aspect of the present disclosure, the battery management apparatus has an advantage of being able to diagnose the degradation state of the battery into more stages based on the change patterns of voltage and resistance.

In addition, according to one aspect of the present disclosure, the battery management apparatus has an advantage of being able to effectively prevent degradation or accelerated degradation of the battery by controlling the battery in a manner suitable for each degradation stage according to the diagnosis results.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically illustrating a battery management apparatus according to an embodiment of the present disclosure.
FIG. 2 is a drawing schematically illustrating a battery profile according to an embodiment of the present disclosure.
FIG. 3 and FIG. 4 are drawings for reference in explaining a specific embodiment in which the battery management apparatus according to the present disclosure determines a voltage pattern and a resistance pattern.
FIG. 5 is a drawing for reference in explaining a specific embodiment in which the battery management apparatus according to the present disclosure diagnoses a state of a battery.
FIG. 6 is a drawing illustrating an exemplary configuration of a battery pack according to another embodiment of the present disclosure.
FIG. 7 is a drawing schematically illustrating an exemplary configuration of a vehicle according to still another embodiment of the present disclosure.
FIG. 8 is a drawing schematically illustrating a battery management method according to still another embodiment of the present disclosure.

### BEST MODE

Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just an example for the purpose of illustrations only, not intended to limit the scope of the disclosure, so it should be understood that other equivalents and modifications could be made thereto without departing from the scope of the disclosure.

In addition, when explaining the present disclosure, if it is judged that the detailed description of the related known structure or function may obscure the main point of the present disclosure, the detailed description will be omitted.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, an embodiment of the present disclosure will be described in detail with reference to the attached drawings.

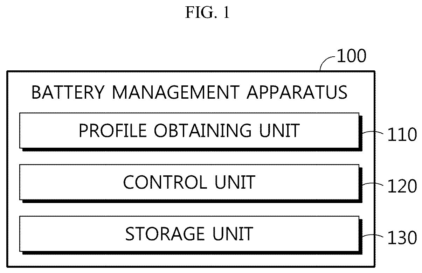

FIG. 1 is a diagram schematically illustrating a battery management apparatus 100 according to an embodiment of the present disclosure.

Referring to FIG. 1, a battery management apparatus 100 according to an embodiment of the present disclosure may include a profile obtaining unit 110 and a control unit 120. The battery management apparatus 100 may further include a storage unit 130.

Here, the battery refers to an independent cell that has a negative electrode terminal and a positive electrode terminal and is physically separable. As an example, a lithium-ion cell or a lithium polymer cell may be considered as a battery. Additionally, the type of battery may be cylindrical type, prismatic type, or pouch type. In addition, the battery may mean a battery bank, a battery module, or a battery pack in which a plurality of cells are connected in series and/or parallel. Hereinafter, for convenience of explanation, the battery is explained as meaning one independent cell.

The profile obtaining unit 110 may be configured to obtain a battery profile representing a corresponding relationship between the resistance and voltage of the battery.

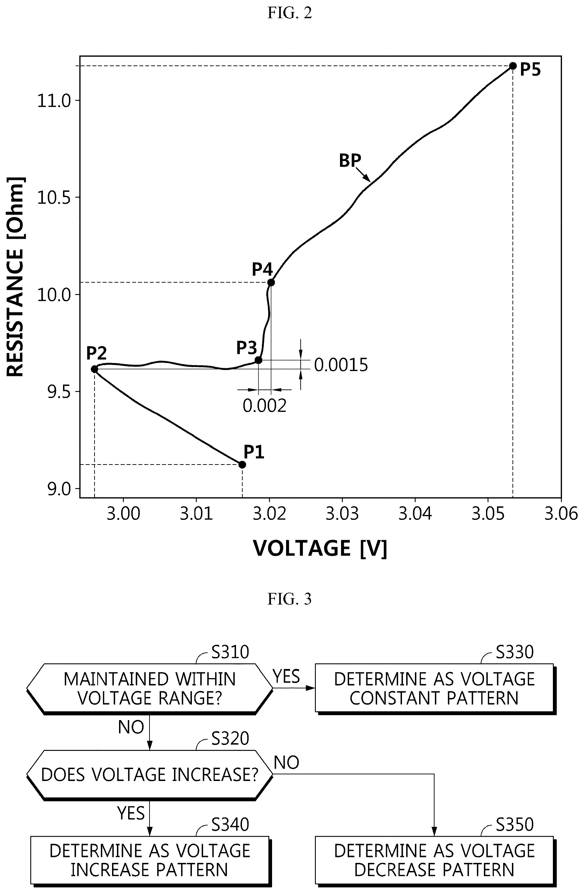

FIG. 2 is a drawing schematically illustrating a battery profile BP according to an embodiment of the present disclosure.

In the embodiment of FIG. 2, the horizontal axis (X-axis) represents voltage [V], and the vertical axis (Y-axis) represents resistance [Ohm].

The embodiment of FIG. 2 is a schematic diagram illustrating a battery profile BP representing a corresponding relationship between voltage and resistance measured at each predetermined charge/discharge cycle from the BOL (Beginning of Life) state to the EOL (End of Life) state of the battery. For example, P1 represents the voltage and resistance measured when the battery is in the BOL state, and P5 represents the voltage and resistance measured when the battery is in the EOL state. In other words, the state of the battery is degraded as it goes from P1 to P5.

According to an embodiment, the voltage constituting the battery profile BP may be the voltage after discharge termination of the battery, and the resistance may be the resistance after discharge termination of the battery. In other words, the battery profile BP may be a profile representing a corresponding relationship between the voltage and the resistance after a predetermined time has passed after the discharge of the battery is terminated.

For example, the battery profile BP may be a profile that represents the corresponding relationship between voltage and resistance measured after a predetermined time has elapsed from the termination of discharge for each predetermined discharge cycle.

The battery may be discharged until the voltage (or SOC) reaches a preset discharge termination voltage (or preset discharge termination SOC). The profile obtaining unit 110 may calculate the resistance of the battery based on the voltage change amount from the time when the voltage of the battery reaches the discharge termination voltage until a predetermined period of time has elapsed.

For example, it is assumed that the discharge current is Id, the discharge termination voltage is Vi, and the voltage after a predetermined time after the discharge of the battery is terminated is Vf. In this case, the profile obtaining unit 110 may calculate the resistance of the battery by calculating the formula of "(Vf - Vi) ÷ Id" using Ohm's law. Here, the predetermined time may be an experimentally or theoretically preset time. For example, the predetermined time may be preset to 1 second or 0.1 second.

In an embodiment, the profile obtaining unit 110 may directly receive the battery profile BP from the outside. That is, the profile obtaining unit 110 may obtain the battery profile BP by being connected to the outside by wire and/or wirelessly and receiving the profile.

In another embodiment, the profile obtaining unit 110 may receive battery information about the resistance and voltage of the battery. Then, the profile obtaining unit 110 may generate a battery profile BP based on the received battery information. That is, the profile obtaining unit 110 may obtain the battery profile BP by directly generating the battery profile BP based on the battery information.

As another example, the profile obtaining unit 110 may directly measure the voltage and current of the battery. For example, the profile obtaining unit 110 may be directly connected to the positive electrode terminal and the negative electrode terminal of the battery to directly measure the voltage of the battery. In addition, the profile obtaining unit 110 may measure the charge and discharge current of the battery and calculate the resistance of the battery based on the measured current. In addition, the profile obtaining unit 110 may generate the battery profile BP based on the voltage and resistance of the battery. That is, the profile obtaining unit 110 may obtain the battery profile BP based on the directly measured voltage and current of the battery.

The profile obtaining unit 110 may be connected to communicate with the control unit 120. For example, the profile obtaining unit 110 may be connected to the control unit 120 by wire and/or wirelessly. The profile obtaining unit 110 may transmit the obtained battery profile to the control unit 120.

The control unit 120 may be configured to determine the voltage pattern and resistance pattern of the battery based on the battery profile BP.

The voltage pattern may include a voltage increase pattern, a voltage decrease pattern, and a voltage constant pattern. And, the resistance pattern may include a resistance increase pattern and a resistance constant pattern.

The control unit 120 may be configured to compare a preset diagnosis rule with the voltage pattern and/or resistance pattern of the battery and diagnose the state of the battery based on the comparison result.

The diagnosis rule may be a rule indicating a corresponding relationship between the voltage pattern and/or resistance pattern of the battery and the state of the battery. The diagnosis rule may be preset and stored in the storage unit 130.

The state of the battery is an indicator representing the degree of degradation of the battery. For example, the state of the battery may be divided into a normal state and a degradation state. In addition, the degradation state may be divided into an initial degradation state and a mid- or late-stage degradation state, and the mid- or late-stage degradation state may be divided into a mid-stage degradation state and a late-stage degradation state. When listing the states in order of the degree of degradation of the battery from a small state to a large state, the states may be listed in the following order: normal state, initial degradation state, mid-stage degradation state, and late-stage degradation state. In other words, if the battery is in a normal state, the battery may be judged to be close to the BOL state, and if the battery is in a late-stage degradation state, the battery may be judged to be close to the EOL state.

The battery management apparatus 100 according to an embodiment of the present disclosure has an advantage of being able to diagnose the degradation state of a battery into more stages based on the change in voltage and resistance.

Meanwhile, the control unit 120 included in the battery management apparatus 100 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

In addition, the battery management apparatus 100 may further include a storage unit 130. The storage unit 130 may store data necessary for operation and function of each component of the battery management apparatus 100, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

Specifically, the storage unit 130 may store information necessary for the control unit 120 to diagnose the state of the battery. For example, the storage unit 130 may store the battery profile BP, the diagnosis rule, etc. In addition, the control unit 120 may access the storage unit 130 to obtain information necessary for diagnosing the state of the battery. For example, the battery profile BP obtained by the profile obtaining unit 110 is stored in the storage unit 130, and the control unit 120 may access the storage unit 130 to obtain the stored battery profile BP.

Below, an embodiment of the battery management apparatus 100 determining a voltage pattern and a resistance pattern is described.

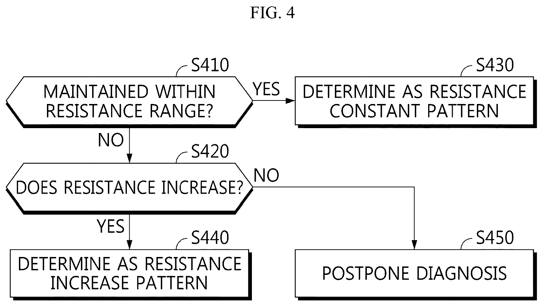

FIG. 3 and FIG. 4 are drawings for reference in explaining a specific embodiment in which the battery management apparatus 100 according to the present disclosure determines a voltage pattern and a resistance pattern.

For example, the voltage range may be a preset range within which the control unit 120 may determine that the voltage of the battery is maintained constantly. Preferably, the voltage range is a range having a size within which the control unit 120 may determine that the voltage of the battery is maintained constantly. The voltage range is preset experimentally or theoretically, and the voltage pattern may be determined depending on whether the voltage change amount of the battery falls within the voltage range. For example, in the embodiment of FIG. 2, the size of the voltage range may be preset to 0.002 [V].

If the voltage of the battery is maintained within the preset voltage range, the control unit 120 may be configured to determine the voltage pattern as a voltage constant pattern. For example, if the voltage of the battery is maintained within the preset voltage range even when the voltage of the battery increases over time, the control unit 120 may be configured to determine the voltage pattern as a voltage constant pattern. As another example, if the voltage of the battery is maintained within the preset voltage range even when the voltage of the battery decreases over time, the control unit 120 may be configured to determine the voltage pattern as a voltage constant pattern.

For example, in the embodiment of FIG. 2, the control unit 120 may determine the voltage pattern of the battery for the section from point P3 to point P4 as a voltage constant pattern.

If the voltage of the battery increases over time and is out of the preset voltage range, the control unit 120 may be configured to determine the voltage pattern as a voltage increase pattern.

For example, in the embodiment of FIG. 2, the control unit 120 may determine the voltage pattern of the battery for the section from point P2 to point P3 and the section from point P4 to point P5 as a voltage increase pattern.

If the voltage of the battery decreases over time and is out of the preset voltage range, the control unit 120 may be configured to determine the voltage pattern as a voltage decrease pattern.

For example, in the embodiment of FIG. 2, the control unit 120 may determine the voltage pattern of the battery for the section from point P1 to point P2 as a voltage decrease pattern.

The resistance range may be a preset range in which the control unit 120 may determine that the resistance of the battery is maintained constantly. Preferably, the resistance range is a range having a size in which the control unit 120 may determine that the resistance of the battery is maintained constantly. The resistance range is preset experimentally or theoretically, and the resistance pattern may be determined depending on whether the resistance change amount of the battery falls within the resistance range. For example, in the embodiment of FIG. 2, the size of the resistance range may be preset to 0.0015 [Ω].

If the resistance of the battery is maintained within the preset resistance range, the control unit 120 may be configured to determine the resistance pattern as the resistance constant pattern. For example, if the resistance of the battery is maintained within the preset resistance range even when the resistance of the battery increases over time, the control unit 120 may be configured to determine the resistance pattern as the resistance constant pattern. As another example, if the resistance of the battery is maintained within the preset resistance range even when the resistance of the battery decreases over time, the control unit 120 may be configured to determine the resistance pattern as the resistance constant pattern.

For example, in the embodiment of FIG. 2, the control unit 120 may determine the resistance pattern of the battery for the section from point P2 to point P3 as a resistance constant pattern.

If the resistance of the battery increases over time and is out of the preset resistance range, the control unit 120 may be configured to determine the resistance pattern as a resistance increase pattern.

For example, in the embodiment of FIG. 2, the control unit 120 may determine the resistance pattern of the battery for the section from point P1 to point P2 and the section from point P3 to point P5 as a resistance increase pattern.

Referring to FIG. 3, in step S310, the control unit 120 may determine whether the voltage of the battery is maintained within the preset voltage range. For example, the control unit 120 may determine whether the voltage of the battery is maintained within the preset voltage range based on a predetermined number of voltage data of the battery profile BP. That is, the control unit 120 may determine whether the voltage of the battery is maintained within the preset voltage range based on the voltage history of a predetermined discharge cycle. If the result of step S310 is YES, step S330 may be performed. If the result of step S310 is NO, step S320 may be performed.

In step S320, the control unit 120 may determine whether the voltage of the battery increases. For example, the control unit 120 may determine whether the voltage of the battery increases based on a predetermined number of voltage data of the battery profile BP. That is, the control unit 120 may determine whether the voltage of the battery increases based on the voltage history of a predetermined discharge cycle. If the result of step S320 is YES, step S340 may be performed. If the result of step S320 is NO, step S350 may be performed.

In step S330, the control unit 120 may determine the voltage pattern of the battery as a voltage constant pattern.

In step S340, the control unit 120 may determine the voltage pattern of the battery as a voltage increase pattern.

In step S350, the control unit 120 may determine the voltage pattern of the battery as a voltage decrease pattern.

Referring to FIG. 4, in step S410, the control unit 120 may determine whether the resistance of the battery is maintained within the preset resistance range. For example, the control unit 120 may determine whether the resistance of the battery is maintained within the preset resistance range based on a predetermined number of resistance data of the battery profile BP. That is, the control unit 120 may determine whether the resistance of the battery is maintained within the preset resistance range based on the resistance history of a predetermined discharge cycle. If the result of step S410 is YES, step S430 may be performed. If the result of step S410 is NO, step S420 may be performed.

In step S420, the control unit 120 may determine whether the resistance of the battery increases. For example, the control unit 120 may determine whether the resistance of the battery increases based on a predetermined number of resistance data of the battery profile BP. That is, the control unit 120 may determine whether the resistance of the battery increases based on the resistance history of a predetermined discharge cycle. If the result of step S420 is YES, step S440 may be performed. If the result of step S420 is NO, step S450 may be performed.

In step S430, the control unit 120 may determine the resistance pattern of the battery as a resistance constant pattern.

In step S440, the control unit 120 may determine the resistance pattern of the battery as a resistance increase pattern.

In step S450, the control unit 120 may postpone the diagnosis of the battery state. After a predetermined period of time has elapsed, the control unit 120 may perform step S410 again.

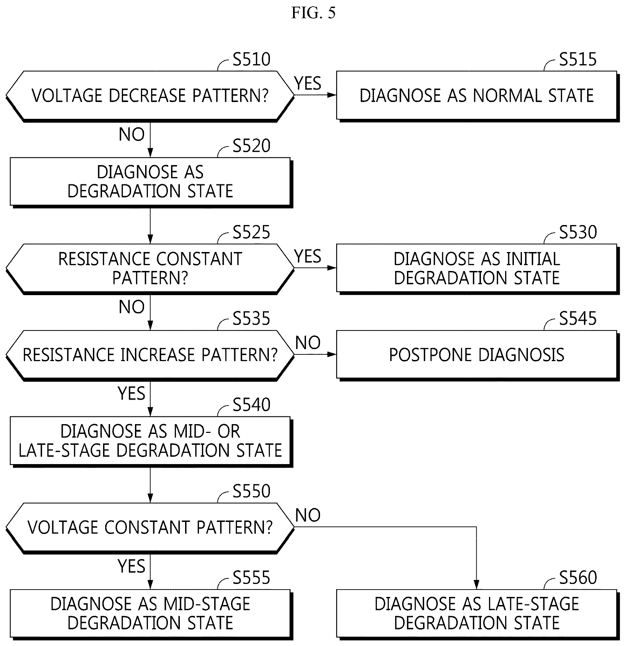

FIG. 5 is a drawing for reference in explaining a specific embodiment in which the battery management apparatus according to the present disclosure diagnoses a state of a battery.

The control unit 120 may compare the voltage pattern and/or resistance pattern of the battery with a preset diagnosis rule and diagnose the state of the battery based on the comparison result.

The control unit 120 may determine whether the voltage pattern of the battery is a voltage decrease pattern. If the voltage pattern of the battery is a voltage decrease pattern, the control unit 120 may diagnose the state of the battery as a normal state. Conversely, if the voltage pattern of the battery is not a voltage decrease pattern, the control unit 120 may diagnose the state of the battery as a degradation state.

If the state of the battery is diagnosed as a degradation state, the control unit 120 may determine whether the resistance pattern of the battery is a resistance constant pattern. If the resistance pattern of the battery is a resistance constant pattern, the control unit 120 may diagnose the state of the battery as an initial degradation state. Conversely, if the resistance pattern of the battery is a resistance increase pattern, the control unit 120 may diagnose the state of the battery as a mid- or late-stage degradation state. In addition, if the resistance pattern of the battery does not correspond to either the resistance constant pattern or the resistance increase pattern, the control unit 120 may postpone the diagnosis of the state of the battery.

If the state of the battery is diagnosed as a mid- or late-stage degradation state, the control unit 120 may determine whether the voltage pattern of the battery is a voltage constant pattern. If the voltage pattern of the battery is a voltage constant pattern, the control unit 120 may diagnose the state of the battery as a mid-stage degradation state. Conversely, if the voltage pattern of the battery is a voltage increase pattern, the control unit 120 may diagnose the state of the battery as a late-stage degradation state.

Referring to FIG. 5, in step S510, the control unit 120 may determine whether the voltage pattern of the battery is a voltage decrease pattern. If the result of step S510 is YES, step S515 may be performed. If the result of step S510 is NO, step S520 may be performed.

In step S515, the control unit 120 may diagnose the state of the battery as a normal state.

In step S520, the control unit 120 may diagnose the state of the battery as a degradation state.

In step S525, the control unit 120 may determine whether the resistance pattern of the battery is a resistance constant pattern. If the result of step S525 is YES, step S530 may be performed. If the result of step S525 is NO, step S535 may be performed.

In step S530, the control unit 120 may diagnose the state of the battery as an initial degradation state.

In step S535, the control unit 120 may determine whether the resistance pattern of the battery is a resistance increase pattern. If the result of step S535 is YES, step S540 may be performed. If the result of step S535 is NO, step S545 may be performed.

In step S540, the control unit 120 may diagnose the state of the battery as a mid- or late-stage degradation state.

In step S545, the control unit 120 may postpone the diagnosis of the battery state. In an embodiment, the control unit 120 may perform step S410 again after a predetermined period of time has elapsed. In another embodiment, the control unit 120 may perform step S510 again after a predetermined period of time has elapsed.

In step S550, the control unit 120 may determine whether the voltage pattern of the battery is a voltage constant pattern. If the result of step S550 is YES, step S555 may be performed. If the result of step S550 is NO, step S560 may be performed.

In step S555, the control unit 120 may diagnose the state of the battery as a mid-stage degradation state.

In step S560, the control unit 120 may diagnose the state of the battery as a late-stage degradation state.

The control unit 120 may be configured to set a usage condition for the battery based on the state of the battery. Since the state of the battery diagnosed by the control unit 120 is an indicator representing the degree of degradation of the battery, the control unit 120 may appropriately set a usage condition related to degradation of the battery based on the state of the battery.

If the battery is diagnosed as a normal state, the control unit 120 may not change the usage condition for the battery. Conversely, if the battery is diagnosed as a degradation state, the control unit 120 may change the usage condition for the battery.

According to one embodiment, when the battery is diagnosed as a degradation state, the control unit 120 may appropriately control the usage condition for the battery according to the degree of degradation of the battery. That is, the control unit 120 may gradually adjust the control strength of the usage condition for the battery according to the diagnosis result. For example, the control unit 120 performs stronger control on a battery diagnosed as a mid-stage degradation state than on a battery diagnosed as an initial degradation state, and the control unit 120 may consider a battery diagnosed as a late-stage degradation state as an abnormal failure and output an alarm recommending the stop of use. According to one embodiment, the receiver of this alarm may be an external device that manages the battery, such as a BMS (Battery Management System), a server, or a user terminal. In addition, the alarm may be output to an external device that diagnoses the battery state, a display, or an audio device.

For example, if the battery is diagnosed as being in a degradation state, the control unit 120 may adjust the charge/discharge rate (C-rate) range for the battery. For example, the control unit 120 may reduce the upper limit of the charge/discharge rate range for the battery.

The control unit 120 may determine a change amount of the charge/discharge rate range for the battery by considering the degree of degradation of the battery. For example, if the battery is diagnosed as a mid- or late-stage degradation state, a mid-stage degradation state, or a late-stage degradation state, the control unit 120 may set an upper limit decrease rate of the charge/discharge rate range to be larger than the case where the battery is diagnosed as an initial degradation state. Similarly, if the battery is diagnosed as a late-stage degradation state, the control unit 120 may set an upper limit decrease rate of the charge/discharge rate range to be larger than the case where the battery is diagnosed as a mid-stage degradation state.

As another example, if the battery is diagnosed as being in a degradation state, the control unit 120 may adjust the available SOC range for the battery. Here, the available SOC range means a range between the minimum SOC and the maximum SOC of the battery during charging or discharging. For example, the control unit 120 may decrease an upper limit of the available SOC range for the battery. As another example, the control unit 120 may increase a lower limit of the available SOC range for the battery. As still another example, the control unit 120 may decrease an upper limit of the available SOC range for the battery and increase a lower limit of the available SOC range.

The control unit 120 may determine a change amount of the available SOC range for the battery by considering the degradation degree of the battery. For example, if the battery is diagnosed as a mid- or late-stage degradation state, a mid-stage degradation state, or a late-stage degradation state, the control unit 120 may set an upper limit decrease rate or a lower limit increase rate of the available SOC range to be larger than the case where the battery is diagnosed as an initial degradation state. Similarly, if the battery is diagnosed as a late-stage degradation state, the control unit 120 may set an upper limit decrease rate or a lower limit increase rate of the available SOC range to be larger than the case where the battery is diagnosed as a mid-stage degradation state.

The battery management apparatus 100 according to an embodiment of the present disclosure may prevent degradation or accelerated degradation of a battery by appropriately setting a usage condition for the battery based on a detailed diagnosis result regarding the degradation state of the battery.

The battery management device according to the present disclosure is connected to a display device (not shown) and may output information on a battery diagnosed as being in an abnormal state. As a result, information on a battery diagnosed as being in an abnormal state may be displayed on the display device.

The battery management device according to the present disclosure is connected to an alarm device (not shown) and may output information on a battery diagnosed as being in an abnormal state to operate the alarm device.

The battery management apparatus 100 according to the present disclosure may be applied to a battery management system (BMS). That is, the BMS according to the present disclosure may include the battery management apparatus 100 described above. In this configuration, at least some of components of the battery management apparatus 100 may be implemented by supplementing or adding functions of the components included in a conventional BMS. For example, the profile obtaining unit 110, the control unit 120 and the storage unit 130 of the battery management apparatus 100 may be implemented as components of the BMS.

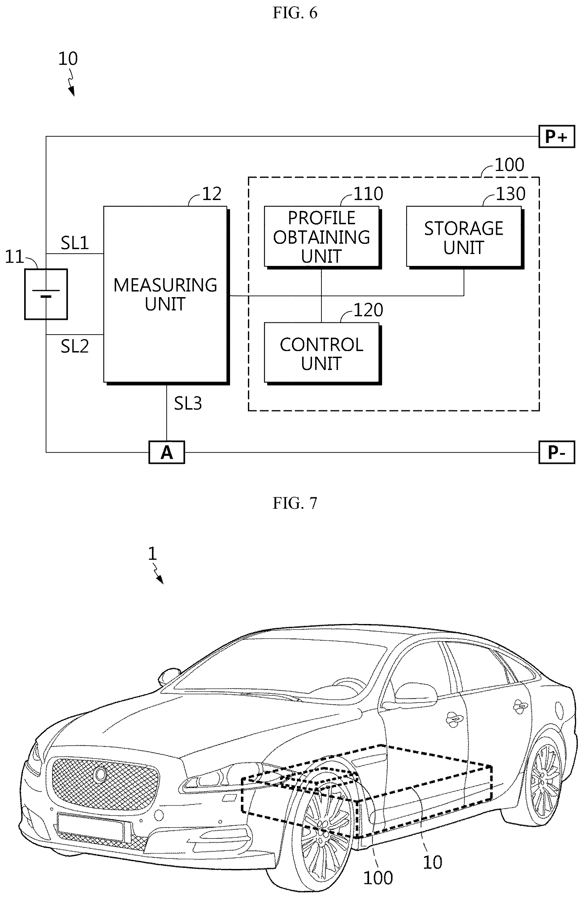

FIG. 6 is a drawing illustrating an exemplary configuration of a battery pack 10 according to another embodiment of the present disclosure.

The battery management apparatus 100 according to the present disclosure may be provided in the battery pack 10. That is, the battery pack 10 according to the present disclosure may include the above-described battery management apparatus 100 and at least one battery cell. Additionally, the battery pack 10 may further include electrical components (relays, fuses, etc.) and a case.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the positive electrode terminal and the negative electrode terminal of the battery 11. Then, the measuring unit 12 may measure the positive electrode potential and the negative electrode potential of the battery 11, and calculate the difference between the positive electrode potential and the negative electrode potential to measure the voltage of the battery 11.

In addition, the measuring unit 12 may be connected to the current measurement unit A. For example, the current measurement unit A may be an ammeter or shunt resistor that may measure the charging current and discharging current of the battery 11. The measuring unit 12 may calculate the charging amount by measuring the charging current of the battery 11 using the current measurement unit A. Additionally, the measuring unit 12 may calculate the discharging amount by measuring the discharging current of the battery 11 through the third sensing line SL3.

One end of an external device (not shown) may be connected to the positive electrode terminal P+ of the battery pack 10, and the other end may be connected to the negative electrode terminal P- of the battery pack 10. Therefore, the positive electrode terminal of the battery 11, the positive electrode terminal P+ of the battery pack 10, the external device, the negative electrode terminal P- of the battery pack 10, and the negative electrode terminal of the battery 11 may be electrically connected.

For example, the external device may be a charging device, or a load such as a motor of an electric vehicle that receives power from the battery 11.

FIG. 7 is a drawing schematically illustrating an exemplary configuration of a vehicle 1 according to still another embodiment of the present disclosure.

Referring to FIG. 7, the battery pack 10 according to an embodiment of the present disclosure may be included in the vehicle 1 such as an electric vehicle (EV) or a hybrid vehicle (HV). Additionally, the battery pack 10 may drive the vehicle 1 by supplying power to the motor through an inverter provided in the vehicle 1. Additionally, the battery pack 10 may include the battery management apparatus 100. That is, the vehicle 1 may include the battery management apparatus 100.

In this case, the battery management apparatus 100 may be an onboard diagnostic device included in the vehicle 1. That is, the battery management apparatus 100 may diagnose the state of the battery based on the profile of the battery included in the vehicle 1. In addition, the battery management apparatus 100 may provide information on the state of the diagnosed battery to the user.

A server according to another embodiment of the present disclosure may include the battery management apparatus 100. For example, the server may receive a profile from a BMS connected to the battery. As another example, the server may receive information on voltage and resistance of the battery from the BMS and directly generate a profile based on the received information.

The server may determine the voltage pattern and resistance pattern of the battery based on the profile. Then, the server may diagnose the state corresponding to the voltage pattern and resistance pattern as the state of the battery according to the preset diagnosis rule. Then, the server may provide state information about the battery by transmitting information about the state of the diagnosed battery to the BMS.

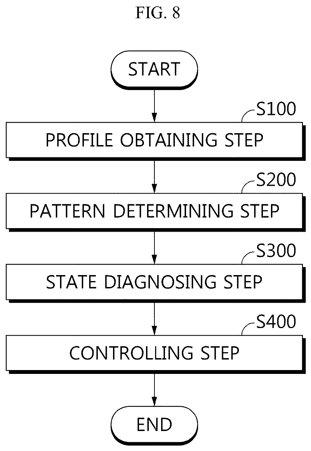

FIG. 8 is a drawing schematically illustrating a battery management method according to still another embodiment of the present disclosure.

Referring to FIG. 8, the battery management method may include a profile obtaining step (S100), a pattern determining step (S200), and a state diagnosing step (S300). The battery management method may further include a controlling step (S400).

Preferably, each step of the battery management method may be performed by the battery management apparatus 100. Hereinafter, for convenience of explanation, the content overlapping with the previously described content will be briefly described or omitted.

The profile obtaining step (S100) is a step of obtaining a profile representing a corresponding relationship between resistance and voltage of a battery, and may be performed by the profile obtaining unit 110.

The pattern determining step (S200) is a step of determining a voltage pattern and a resistance pattern of the battery based on the profile, and may be performed by the control unit 120.

The voltage pattern may include a voltage increase pattern, a voltage decrease pattern, and a voltage constant pattern. And, the resistance pattern may include a resistance increase pattern and a resistance constant pattern.

The voltage range may be a preset range within which the control unit 120 may determine that the voltage of the battery is maintained constantly.

If the voltage of the battery is maintained within the preset voltage range, the control unit 120 may be configured to determine the voltage pattern as a voltage constant pattern. For example, if the voltage of the battery is maintained within the preset voltage range even when the voltage of the battery increases over time, the control unit 120 may be configured to determine the voltage pattern as a voltage constant pattern. As another example, if the voltage of the battery is maintained within the preset voltage range even when the voltage of the battery decreases over time, the control unit 120 may be configured to determine the voltage pattern as a voltage constant pattern.

If the voltage of the battery increases over time and is out of the preset voltage range, the control unit 120 may be configured to determine the voltage pattern as a voltage increase pattern.

If the voltage of the battery decreases over time and is out of the preset voltage range, the control unit 120 may be configured to determine the voltage pattern as a voltage decrease pattern.

The resistance range may be a preset range within which the control unit 120 may determine that the resistance of the battery is maintained constantly.

If the resistance of the battery is maintained within the preset resistance range, the control unit 120 may be configured to determine the resistance pattern as the resistance constant pattern. For example, if the resistance of the battery is maintained within the preset resistance range even when the resistance of the battery increases over time, the control unit 120 may be configured to determine the resistance pattern as the resistance constant pattern. As another example, if the resistance of the battery is maintained within the preset resistance range even when the resistance of the battery decreases over time, the control unit 120 may be configured to determine the resistance pattern as the resistance constant pattern.

If the resistance of the battery increases over time and is out of the preset resistance range, the control unit 120 may be configured to determine the resistance pattern as a resistance increase pattern.

The state diagnosing step (S300) is a step of comparing a preset diagnosis rule with the voltage pattern and the resistance pattern and diagnosing the state of the battery based on the comparison result, and may be performed by the control unit 120.

The control unit 120 may determine whether the voltage pattern of the battery is a voltage decrease pattern. If the voltage pattern of the battery is a voltage decrease pattern, the control unit 120 may diagnose the state of the battery as a normal state. Conversely, if the voltage pattern of the battery is not a voltage decrease pattern, the control unit 120 may diagnose the state of the battery as a degradation state.

If the state of the battery is diagnosed as a degradation state, the control unit 120 may determine whether the resistance pattern of the battery is a resistance constant pattern. If the resistance pattern of the battery is a resistance constant pattern, the control unit 120 may diagnose the state of the battery as an initial degradation state. Conversely, if the resistance pattern of the battery is a resistance increase pattern, the control unit 120 may diagnose the state of the battery as a mid- or late-stage degradation state. In addition, if the resistance pattern of the battery does not correspond to either the resistance constant pattern or the resistance increase pattern, the control unit 120 may postpone the diagnosis of the state of the battery.

If the state of the battery is diagnosed as a mid- or late-stage degradation state, the control unit 120 may determine whether the voltage pattern of the battery is a voltage constant pattern. If the voltage pattern of the battery is a voltage constant pattern, the control unit 120 may diagnose the state of the battery as a mid-stage degradation state. Conversely, if the voltage pattern of the battery is a voltage increase pattern, the control unit 120 may diagnose the state of the battery as a late-stage degradation state.

The controlling step (S400) is a step of setting a usage condition for the battery based on the state diagnosis result, and may be performed by the control unit 120.

For example, the control unit 120 may adjust the charge/discharge rate range or the available SOC range for the battery.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### [Explanation of symbols]

1: vehicle
10: battery pack
11: battery
12: measuring unit
100: battery management apparatus
110: profile obtaining unit
120: control unit
130: storage unit

## Claims

1. A battery management apparatus, comprising:
a profile obtaining unit configured to obtain a battery profile representing a corresponding relationship between resistance and voltage of a battery; and
a control unit configured to determine a voltage pattern and a resistance pattern of the battery based on the battery profile, compare at least one of the voltage pattern and the resistance pattern with a preset diagnosis rule, and diagnose a state of the battery based on the comparison result.

2. The battery management apparatus according to claim 1,
wherein the voltage pattern is configured to include a voltage increase pattern, a voltage decrease pattern, and a voltage constant pattern, and
wherein the resistance pattern is configured to include a resistance increase pattern and a resistance constant pattern.

3. The battery management apparatus according to claim 2,
wherein the control unit is configured to determine the voltage pattern as the voltage constant pattern when the voltage of the battery is maintained within a preset voltage range,
wherein the control unit is configured to determine the voltage pattern as the voltage increase pattern when the voltage of the battery increases over time and is out of the voltage range, and
wherein the control unit is configured to determine the voltage pattern as the voltage decrease pattern when the voltage of the battery decreases over time and is out of the voltage range.

4. The battery management apparatus according to claim 2,
wherein the control unit is configured to determine the resistance pattern as the resistance constant pattern when the resistance of the battery is maintained within a preset resistance range, and
wherein the control unit is configured to determine the resistance pattern as the resistance increase pattern when the resistance of the battery increases over time and is out of the resistance range.

5. The battery management apparatus according to claim 2,
wherein the control unit is configured to diagnose the state of the battery as a normal state when the voltage pattern is the voltage decrease pattern, and
wherein the control unit is configured to diagnose the state of the battery as a degradation state when the voltage pattern is not the voltage decrease pattern.

6. The battery management apparatus according to claim 5,
wherein in case where the state of the battery is the degradation state, the control unit is configured to diagnose the state of the battery as an initial degradation state when the resistance pattern is the resistance constant pattern, and to diagnose the state of the battery as a mid- or late-stage degradation state when the resistance pattern is the resistance increase pattern.

7. The battery management apparatus according to claim 6,
wherein in case where the state of the battery is the mid- or late-stage degradation state, the control unit is configured to diagnose the state of the battery as a mid-stage degradation state when the voltage pattern is the voltage constant pattern, and to diagnose the state of the battery as a late-stage degradation state when the voltage pattern is the voltage increase pattern.

8. The battery management apparatus according to claim 1,
wherein the control unit is configured to set a usage condition for the battery based on the state of the battery.

9. The battery management apparatus according to claim 1,
wherein the voltage that constitutes the battery profile is a voltage after a discharge termination of the battery, and the resistance that constitutes the battery profile is a resistance after the discharge termination of the battery.

10. The battery management apparatus according to claim 1, further comprising:
a display coupled with the control unit,
wherein the control unit is configured to output the diagnosis result through the display.

11. A battery pack, comprising the battery management apparatus according to any one of claims 1 to 10.

12. A vehicle, comprising the battery management apparatus according to any one of claims 1 to 10.

13. A server, comprising the battery management apparatus according to any one of claims 1 to 10.

14. A battery management method, comprising:
a profile obtaining step of obtaining a battery profile representing a corresponding relationship between resistance and voltage of a battery;
a pattern determining step of determining a voltage pattern and a resistance pattern of the battery based on the battery profile; and
a state diagnosing step of comparing the voltage pattern and the resistance pattern with a preset diagnosis rule and diagnosing a state of the battery based on the comparison result.
